# EUROPEAN PATENT APPLICATION

(11) **EP 1 271 541 A2**
(43) Date of publication of application: **02.01.2003**
(21) Application number: 02090216.9
(22) Date of filing: 15.06.2002
(51) Int. Cl.: G11C 7/10

(54) **Data storing circuit and data processing apparatus**

(30) Priority: 21.06.2001 JP 2001188250
(71) Applicant: NEC CORPORATION, Tokyo (JP)
(72) Inventor: Takeshita, Miyuki, NEC Micro Systems, Ltd., Kawasaki-shi, Kanagawa (JP)
(74) Representative: Patentanwälte Wenzel & Kalkoff

(57) **Abstract**

A data processing apparatus (**100**) varying width data sizes for a data storing device is disclosed and may include a data storage circuit (**201**), a read/write switch circuit (**103**), an address generating circuit (**104**), and a selection signal generating circuit (**202**). Data storage circuit (**201**) may include at least one memory array (**112**), a selecting circuit (**211** and **212**), a read circuit (**214**) and a write circuit (**213**). Selecting circuit (**211** and **212**) may select a plurality of data bits from the memory array (**112**) in a first mode and may select N times the plurality of data bits from the memory array (**112**) in a second mode. Thus, the data storage circuit (**201**) may be shared by, for example, processors having different data widths.

## Description

### TECHNICAL FIELD

The present invention relates to configuration of data widths in general and particularly to selection of N times in width of input data sizes for a data storing circuit.

### BACKGROUND OF THE INVENTION

In a data processing system having a microcomputer or the like, data storage circuits may be connected to a central processing circuit. Various data storage circuits may include a memory array, such as a random access memory (RAM), read only memory (ROM), or the like. A data storage circuit may store data values with a predetermined data-width. A central processing circuit can be a central processing unit (CPU). A central processing unit (CPU) may process data values with a predetermined data-width, such as 8 bits or 16 bits.

Typically, when a data processing apparatus is configured, a central processing unit (CPU) and a data storage circuit may be connected so that both may have a common data-width. However, when two central processing circuits having different data widths are connected to a single data storage circuit (by way of a data bus, for example), a corresponding data width for a data storage circuit may be selected accordingly.

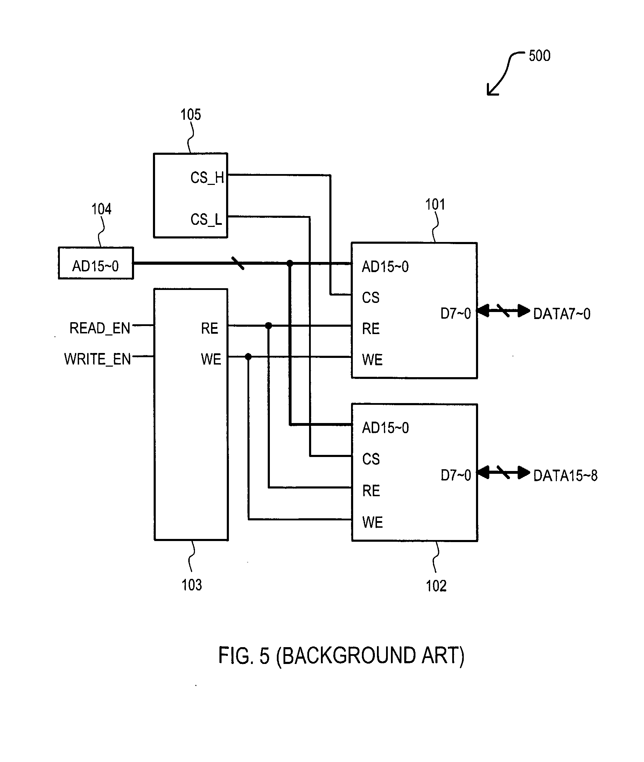

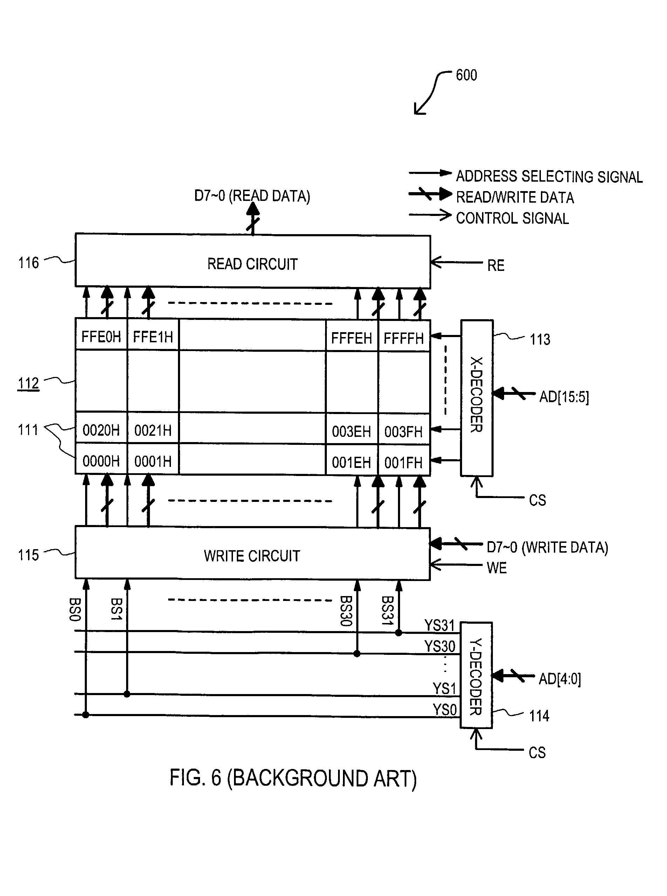

A conventional data processing apparatus for selection of a corresponding data width will now be described in the following FIGS. 5 and 6.

Referring to FIG. 5, a conventional data processing apparatus for selection of a corresponding data width is set forth and designated by the general reference number **500.** This includes a first data storage circuit **101,** a second data storage circuit **102,** a read/write switch circuit **103,** an address generating circuit **104**, and a selection signal generating circuit **105.**

First data storage circuit **101** and second data storage circuit **102** may each include a RAM array or an Electrically Erasable Programmable Read Only Memory array (EEPROM). A memory array may include rows and columns of memory cells. First and second data storage circuits **101** or **102** store data values.

In addition, first data storage circuit **101** and second data storage circuit **102** receive data values **DATA 7-0** and **DATA 15-8,** respectively, having an 8-bit data width. Data values stored in first and second data storage circuit **101** or **102** can be read upon receiving a read signal **RE** from read/write switch circuit **103.** First data storage circuit **101** or second data storage circuit **102** will be described in more detail in FIG. 6.

Read/write switch circuit **103** receives a read enable signal **READ_EN** and a write enable signal **WRITE_EN**. Read/write switch circuit **103** selectively activates and outputs a write signal **WE** or a read signal **RE** to a first data storage circuit **101** and a second data storage circuit **102.** Read/write switch circuit **103** will be described in greater detail in FIG. 6.

Address generating circuit **104** is connected to first data storage circuit **101** and second data storage circuit **102.** Address generating circuit **104** generates an address **AD15-0** for each cell of a memory array in first data storage circuit **101** and second data storage circuit **102.** A typical address can be of a 16-bits, for example.

First data storage circuit **101** and second data storage circuit **102** receive an address **AD15-0** from address generating circuit **104.** Address **AD15-0** is decoded to select a corresponding memory cell on a memory array. Address **AD15-0** can be received in parallel with an enable signals, such as a **READ_EN** or **WRITE_EN,** by first data storage circuit **101** and second data storage circuit **102.**

Selection signal generating circuit **105** provides a selection signal **CS** to first data storage circuit **101** and/or second data storage circuit **102.** A selection signal from an output **CS_H** is transmitted to first data storage circuit **101.** A selection signal from an output **CS_L** is transmitted to second data storage circuit **102.** In this way, a selection signal generating circuit **105** selectively controls operations in first data storage circuit **101** and/or second data storage circuit **102.**

In FIG. 6, a conventional data storage circuit including a read/write switch circuit is set forth and designated by the general reference number **600,** which includes a number of memory arrays **112,** an X-decoder **113** and a Y-decoder **114**, a read circuit **116** and a write circuit **115**.

Memory array **112** includes a number of memory cells **111**. Typically, a memory cell **111** on conventional data storage circuit **600** may have a 2,048 × 32 layout, 2048 rows and 32 columns, for example. Each memory cell **111** has an address value ranging from 0000 to FFFF. Each address value can correspond to a point value having both an X-axis and Y-axis indications. In this example, memory cells **111** are memory cell groups selectable by an address value. Each memory cell group **111** stores an 8-bit data value.

X-decoder **113** and Y-decoder **114** respectively activate a row and a column to select a memory cell **111** on memory array **112**. X-decoder **113** and Y-decoder **114** are connected between memory array **112** and address generating circuit **104** (FIG. 6).

X-decoder **113** and Y-decoder **114,** respectively, receive an input of an address value from address generating circuit **104** and decode it to an X-axis value and a Y-axis value, respectively. X-decoder **113** and Y-decoder **114** may then output decoded signals that activate a row and a column to a cell selecting circuit to select a memory cell **111** with a corresponding address.

X-decoder **113** and Y-decoder **114** also receive a selection signal **CS** generated by selection signal generating circuit **105.** Thus, whether first data storage circuit **101** or second data storage circuit **102** is activated may depend upon a selection signal that selects either first data storage circuit **101** or second data storage circuit **102** and a memory cell **111** from the selected data storage circuit **(101** and **102).**

For example, address generating circuit **104** in FIG. 5 may generate and provide an address value to X-decoder **113** and Y-decoder **114** in first or second data storage circuit **101** or **102.** X-decoder **113,** for example, receives an 11-bit value **AD[15:5]** and decodes it to select one of 2048 rows. Y-decoder **114** receives and decodes a 5-bit value **AD[4:0]** to select one of 32 columns. Thus, a memory cell with a corresponding row and column is selected accordingly for a read and/or write operation, or the like.

Conventional data storage circuit **600** further includes conventional write circuit **115** and read circuit **116,** which write data into and read data from, respectively, a memory cell **111** in memory array **112.** Depending upon whether a write-enable signal, **WRITE_EN** or a read-enable signal, **READ_EN,** is enabled, write circuit **115** or read circuit **116** receive a write command **WE** or a read command **RE.** A write or read operation is thus activated and data values are written into or read from a memory cell **111**.

Referring once again to FIG. 5, a read/write operation performing on first data storage circuit **101** or second data storage circuit **102** are controlled by read/write switching circuit **103.** Read/write switching circuit **103** may output either a read or a write signal to control a data storage circuit. First data storage circuit **101** or second data storage circuit **102** each process a data value of 8-bit wide.

Having described a conventional data storage circuit, various conventional operations will now be described.

A conventional operation includes three kinds of operation modes, a first 8-bit mode, a second 8-bit mode and a 16-bit mode. Each of the three operation modes involves different data storage circuits.

A first 8-bit operation mode involves only first data storage circuit **101.** Second data storage circuit **102** is not involved. Data values of an 8-bit width **DATA 7-0** is received and processed at first data storage circuit **101.**

A second 8-bit operation mode involves only second data storage circuit **102**. First data storage circuit **101** is not involved. Data values of an 8-bit width **DATA 15-8** is received and processed at second data storage circuit **102.**

A 16-bit operation mode involves both first data storage circuit **101** and second data storage circuit **102.** Both data values of **DATA 7-0** and **DATA 15-8** are received and processed at first data storage circuit **101** and second data storage circuit **102** simultaneously. In this way, a data value of a 16-bit width with each of two 8-bit data values is processed in two data storage circuits at the same time. As a result, a 16-bit select output may be generated.

Such use of a plurality of data widths is needed, for example, when two CPUs, or the like, having different data widths are sharing the same memory. For example, a first CPU can have an 8-bit data path and a second CPU can have a 16-bit data path.

However, drawbacks of conventional data processing apparatus become apparent when data values of more than 8-bit width are processed. When a data value of 16-bit width is received, an individual data storage circuit is not sufficient to process a data value of a 16-bit width. A combination of both first data storage circuit **101** and second data storage circuit **102** is thus necessary to process data values of 16-bit width. The parallel use of both circuits **101** and **102** increases complexity and inefficiency of a data processing circuit. Also, the use of both data storage circuits **101** and **102** uses more board space and increases costs.

It is therefore desirable to obtain a data process apparatus that is capable of processing varying width data more efficiently.

### SUMMARY OF THE INVENTION

According to the embodiments, a data processing apparatus may include a data storage circuit, a read/write switch circuit, an address generating circuit, and a selection signal generating circuit. Unlike a conventional data processing apparatus, a data processing apparatus according to a first embodiment may include a single data storage circuit. A single data storage circuit may include at least one memory array, a selecting circuit, a read circuit and a write circuit. A selecting circuit may select a plurality of data bits from a memory array in a first mode and may select N times the plurality of data bits from a memory array in a second mode. In this way, a single data storage circuit may be shared by, for example, processors having different data widths.

According to one aspect of the embodiments, a data processing apparatus may include a selection circuit that selects a first plurality of data bits from a memory array in a first mode and selects N times the first plurality of data bits from the memory array in a second mode wherein N is an integer of 2 or greater.

According to one aspect of the embodiments, the data processing apparatus may be included on a semiconductor device.

According to one aspect of the embodiments, the selection circuit may be coupled to a data bus for receiving at least the first plurality of data bits and coupled to a first and a second processor and the first processor has a different data width than the second processor.

According to one aspect of the embodiments, the data processing apparatus may further include a data write circuit which may receive the plurality of decode signals and may write to memory cells storing the first plurality of data bits in the memory array in the first mode. The data write circuit may write to memory cells storing the N times the first plurality of data bits in the memory array in the second mode.

According to one aspect of the embodiments, the data processing apparatus may further include a data read circuit. This may be coupled to receive the plurality of decode signals and may provide the first plurality of data bits from the memory array in the first mode and provide the N times the first plurality of data bits from the memory array in the second mode.

According to the invention, a data processing apparatus may include a memory array having a plurality of columns and rows of memory, a width-selection signal generating circuit that generates a width-selection signal having an n-bit width logic level and an m-bit width logic level, n being an integer greater than l and m being greater than n, a cell selecting circuit coupled to receive plural address bits and output a plurality of decode signals; and a data write circuit coupled to receive the plurality of decode signals and write the n-bit data to the memory array when the width-selection signal has the n-bit width logic level and the m-bit data into the memory array when the width-selection signal has the m-bit logic level.

According to one aspect of the embodiments, the cell selecting circuit may include a plurality of selector circuits, each selector circuit coupled to receive the width-selection signal and provide at least two decode signals of the plurality of decode signals.

According to one aspect of the embodiments, each selector circuit of the plurality of selector circuits may generate the at least two decode signals based on select signals and the width-selection signal and an activated one of the selector circuit provides a first number of active decode signals when the width-selection signal has the m-bit logic level and less than the first number of active decode signals when the width-selection signal has the n-bit logic level.

According to one aspect of the embodiments, the select signals may be provided by a decoder in accordance with at least a first and second address bit of the plurality of address bits.

According to one aspect of the embodiments, the plurality of selector circuits may include a first selector group and a second selector group that are selectable in accordance with a third address bit of the plurality of address bits.

According to the embodiments, a data processing apparatus may further include a data read circuit coupled to receive the plurality of decode signals and the n-bit data to the memory array when the width-selection signal has the n-bit width logic level and the m-bit data into the memory array when the width-selection signal has the m-bit logic level.

According to one aspect of the embodiments, each selector circuit of the plurality of selector circuits may generate the at least two decode signals based on select signals and the width-selection signal; and an activated selector circuit provides a first number of active decode signals when the width-selection signal has the m-bit logic level and less than the first number of active decode signals when the width-selection signal has the n-bit logic level.

According to one aspect of the embodiments, a data processing apparatus may further include a read/write switch circuit that switches on a read function or a write function.

According to another aspect of the embodiments, an address generating circuit may provide the plurality of address bits.

According to the embodiments, a data processing apparatus may include a memory array having a plurality of columns and rows of memory; a width-selection signal generating circuit that generates a width-selection signal having an n-bit width logic level and an m-bit width logic level; a cell selecting circuit coupled to receive a plurality of address bits and output a plurality of decode signals; and a data read circuit coupled to receive the plurality of decode signals and n-bit data to the memory array when the width-selection signal has the n-bit width logic level and m-bit data into the memory array when the width-selection signal has the m-bit logic level.

According to one aspect of the embodiments, the cell selecting circuit may include a plurality of selector circuits, each selector circuit coupled to receive the width-selection signal and provide at least two decode signals.

According to one aspect of the embodiments, the select signals may be provided by a decoder in accordance with at least a first and second address bit of the plurality of address bits.

According to one aspect of the embodiments, the data processing apparatus may be included on a semiconductor device.

According to one aspect of the embodiments, the plurality of selector circuits may include a first selector group and a second selector group that are selectable in accordance with a third address bit of the plurality of address bits.

According to one aspect of the embodiments, a data processing apparatus may further include a data write circuit coupled to receive the plurality of decode signals and write the n-bit data to the memory array when the width-selection signal has the n-bit width logic level and the m-bit data into the memory array when the width-selection signal has the m-bit logic level.

According to one aspect of the embodiments, a data processing apparatus may further include a read/write switch circuit that switches on a read function or a write function.

According to another aspect of the embodiments, the width selection signal may have an m-bit logic level and an n-bit logic level and m may be an integer multiple of n.

### BRIEF DESCRIPTION OF THE DRAWINGS

FIG. 1 is a block diagram of a data processing apparatus according to one embodiment.

FIG. 2 is a block diagram of a data storage circuit according to an embodiment.

FIG. 3 is a block diagram of a cell selecting circuit including a first and a second Y-decoder according to an embodiment.

FIG. 4 is a block diagram of a write circuit according to an embodiment.

FIG. 5 is a block diagram of a conventional data processing apparatus for selection of a corresponding data width.

FIG. 6 is a block diagram of a conventional data storage circuit and a read/write switch circuit.

### DETAILED DESCRIPTION OF THE EMBODIMENTS

Various embodiments of the present invention will now be discussed in conjunction with a number of figures. The embodiments set forth apparatus and methods for providing varying data widths.

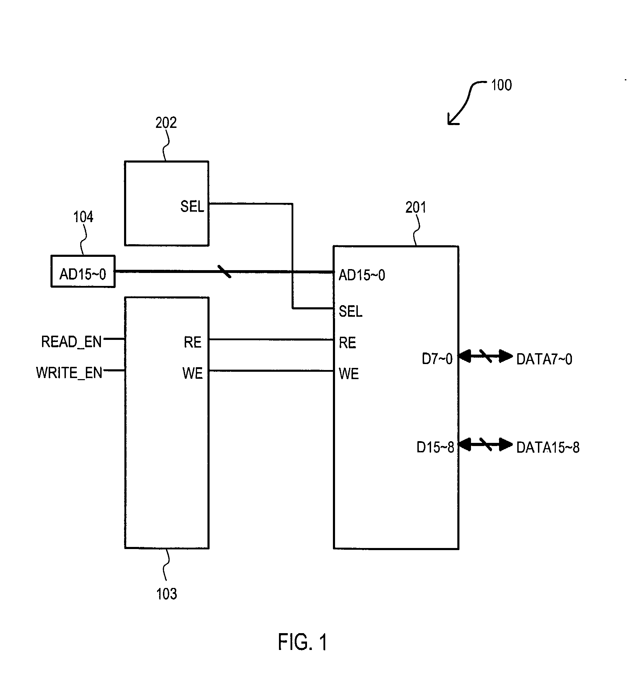

Referring now to FIG. 1, a data processing apparatus according to a first embodiment is set forth and designated by the general reference number **100.** A data processing apparatus **100** may include a data storage circuit **201,** a read/write switch circuit **103,** an address generating circuit **104,** and a selection signal generating circuit **202**. Unlike a conventional data processing apparatus, a data processing apparatus **100** according to a first embodiment may include a single data storage circuit **201.**

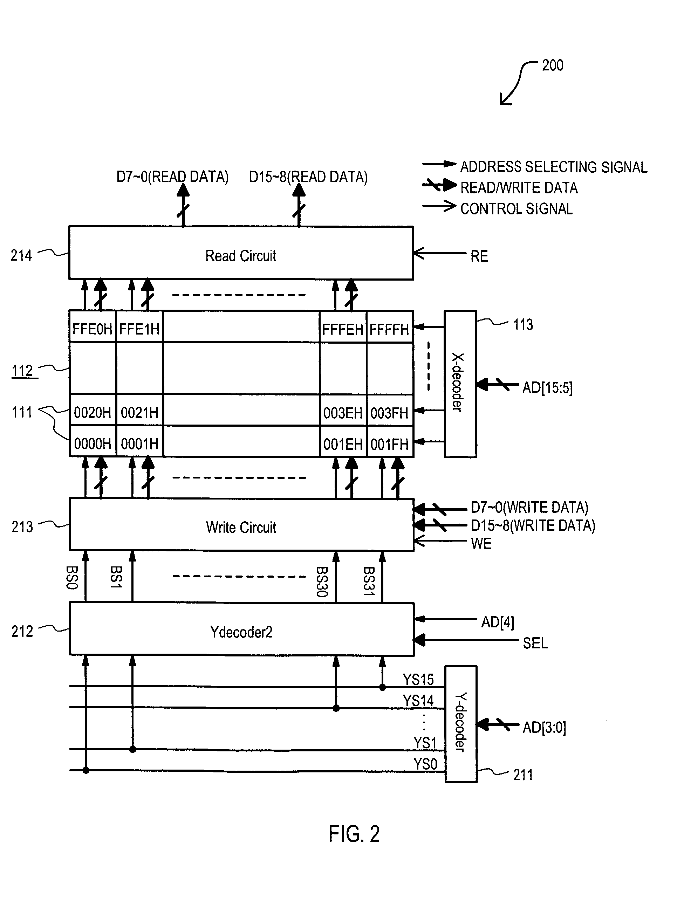

Data storage circuit **201** may each include a RAM array or an electrically erasable programmable read only memory array (EEPROM), or the like. A memory array may include rows and columns of memory cells and store data values. In addition, data storage circuit **201** may input and output data values with an 8-bit width or a 16-bit width. Data values stored in data storage circuit **201** may be available for reading and/or writing upon receiving a read enable **RE** or a write enable signal **WE** from read/write switch circuit **103**. Data storage circuit **201** will be described in more detail in FIG. 2.

The read/write switch circuit **103** may receive a read enable signal **READ_EN** and/or a write enable signal **WRITE_EN** and output either one accordingly. Thus, read/write switch circuit **103** may selectively read and/or write data values from data storage circuit **201** depending upon a type of enable signals that may be received. A read/write switch circuit **103** will be described in more detail in FIG. 2.

The address generating circuit **104** may be connected to data storage circuit **201**, and generate an address for each cell or entry of a memory array located on data storage circuit **201.** A typical address may be of a 16-bit size, for example. Data storage circuit **201** may receive an address from address generating circuit **104** and select a corresponding memory cell on a memory array. An address output from address generating circuit **104** may be received in parallel with an enable signals, such as a read enable **RE** and/or write enbale **WE** by data storage circuit **201**.

A selection signal generating circuit **202** may generate and input a selection signal **SEL** to data storage circuit **201.** Unlike a conventional data process apparatus, selection signal generating circuit **202** may generate a selection signal **SEL** to distinguish (designate) a data operation mode between an 8-bit mode and a 16-bit mode. When an 8-bit a data value is received, a selection signal **SEL** having a high logic level may be generated as an output to indicate that a process operation may be in an 8-bit mode. On the contrary, when a 16-bit data value is received, a selection signal **SEL** having a low logic level may be generated as an output to indicate that a process operation may be a 16-bit mode. In this way, a switch between an 8-bit mode and a 16-bit mode may be controlled by a selection signal **SEL.**

Unlike a conventional data processing apparatus, selection signal generating circuit **202** may selectively control operations in data storage circuit **201** by outputting a control signal **SEL** that may switch on a desired operation mode. In addition, only a single data storage circuit **201** may be utilized to process data values having differing widths of an input data.

Referring now to FIG. 2, a data storage circuit according to an embodiment is set forth and designated by the general reference number **200.** Data storage circuit **200** may be used as data storage circuit **201** in FIG. 1.

Data storage circuit **200** may include at least one memory array **112,** a cell selecting circuit including an X-decoder **113,** a first Y-decoder **211,** a second Y-decoder **212,** a read circuit **213** and a write circuit **214.** Unlike a conventional data storage circuit, data storage circuit **200** according to one embodiment may include an additional second Y-decoder **212.**

Memory array **112** may include a number of memory cells **111**. Typically, a memory cell **111** on memory array **112** may have a 2,048 × 32 layout, 2048 rows and 32 columns. Each memory cell **111** may have a unique address value ranging from 0000 to FFFF, for example. Each address value may correspond to a point value having both an X-axis and a Y-axis indication. Although illustrated as a memory cell **111,** memory cells **111** may include, for example eight individual memory cells and may thus store an 8-bit data value.

X-decoder **113** may select a row of memory cells **111** on memory array **112.** X-decoder **113** may be connected between memory array **112** and address generating circuit **104**.

X-decoder **113** may receive an input of an address value from an address generating circuit **104** and decode it to select a row. X-decoder **113,** as a part of a cell selecting circuit, may select a row of memory cells **111** in accordance with a row address.

Decoded address values by X-decoder **112** and first Y-decoder **211** and second Y-decoder **212** may be generated at different times during a data processing operation.

A cell selecting circuit may include a first Y-decoder **211** and a second Y-decoder **212.** Y-decoder **211** and second Y-decoder **212** generate decoded column address values for memory cells **111** on memory array **112,** and may be connected between memory array **112** and address generating circuit **104.** Y-decoder **211** and second Y-decoder **212** may be also connected to a number of switch circuits for selecting and switching on a number of memory cells.

First Y-decoder **211** and second Y-decoder **212** receive an address from an address generating circuit **104** and decode it to provide column decode signals. A column of memory cells **111** is selected accordingly. A memory cell may thus be located by an activated row and column as decoded by X-decoder **113** and Y-decoders **211** and **212,** respectively.

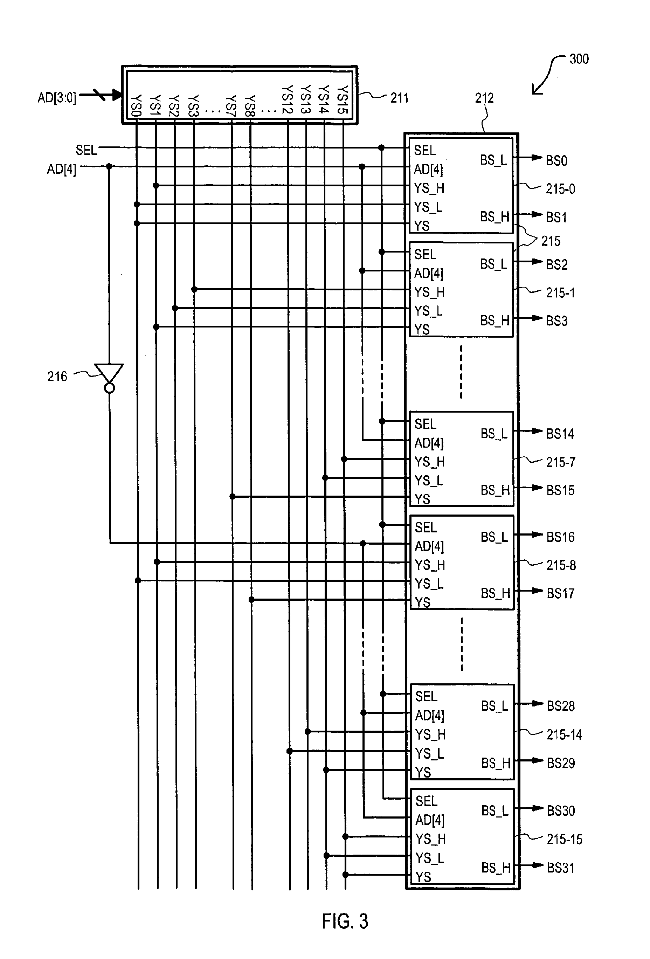

Unlike a conventional approach, second Y-decoder **212** in a data storage circuit according to one embodiment of the present invention may receive a selection signal **SEL** from a selection signal generating circuit **202.** Both first and second Y-decoder **211** and **212** may be involved in generating decode column signals. Second Y-decoder **212** and its operation are described in more detail in FIG. 3.

In a particular arrangement, memory cell **111** may have an address value having both a row address and column address components. Upon receiving an address from address generating circuit **104,** X-decoder **113** may decode an 11-bit address value **"AD [15:5]"** as a lower order of 16-bit address bit "**AD[15,0]**" to 2048 (2¹¹) decoded values.

Data storage circuit **200** may further include a write circuit **213** and a read circuit **214.** A write circuit **213** and a read circuit **214** may write data into or read data from memory array **112,** respectively. Depending upon whether a write-enable signal, **WRITE_EN** or a read-enable signal, **READ_EN**, is activated, write circuit **213** or read circuit **214** may be activated to write data into or read data from memory cell **111**.

Referring now to FIG. 3, a cell selecting circuit including a first and a second Y-decoder according to one embodiment are set forth and designated by the general reference number **300**. A cell selecting circuit **300** includes a first Y-decoder **211** and second Y-decoder **212.** Unlike in a conventional approach, cell selecting circuit **300** may include an additional second Y-decoder **212** that may selectively activate more than one column of memory cells according to the data width of a received data value.

First Y-decoder **211** may output 16 select signals **YS0-15**. The 16 select signals may be divided into 8 groups. Each group of select signals may include a pair of adjacent select signals. Each select signal **YS0-15** may be provided to second Y-decoder **212.**

For example, a first select signal group may include select signals **YS0-YS1**. A first select signal **YS0** may be provided to second Y-decoder **212.** A second select signal **YS1** may be provided to second Y-decoder **212.** Each select signal group may include a low order select signal and an high order select signal. For example first select output group, select signal **YS0** may be considered low order select signal and select signal **YS1** may be considered an high order select signal.

First Y-decoder **211** may receive a data address value and output a decoded data address value (select output) to second Y-decoder **212**. In one particular embodiment, first Y-decoder **211** may receive a data address value of 4-bits, **AD [3:0]**. A data address **AD [3:0]** may be further decoded to 16-bit factors. First Y-decoder **211** may then output decoded 16-bit factors to second Y-decoder **212** on 16 select outputs. It should be noted that only one of the 16-bit factors (select signals **YS0** to **YS15)** may be active in accordance with an address value **AD [3:0]** received.

Having described a first Y-decoder **211,** a second Y-decoder **212** will now be described.

Second Y-decoder **212** may include 16 byte selectors **215 (0-15).** The 16 byte selectors **215 (0-15)** may be connected to a memory array **112.** Second Y-decoder **212** may output data values received from first Y-decoder **211** to cell memory **112** via 32 byte select signals **BS0-BS31**.

The 16 byte selectors **215 (0-15)** may be divided into two groups. Each group of byte selectors may have 8 byte selectors, **215 (0-7)** or **215 (8-15).** A first group of 8 byte selectors **215-0** to **215-7** may be controlled by a fifth address bit control signal, **AD[4]**. A fifth address bit control signal **AD[4]** may also control a second group of 8 byte selectors **215-16** to **215-31** via an inverted signal **AD [4]'** provided by an inverter **216.**

Each byte selector **215** may include a set of select inputs and a set of select outputs. Values may be received from first Y-decoder **211** to each byte selector **215** at a set of select inputs. At a set of select outputs, output selection address values from each byte selector **215** may be provided to allow selection of memory cells **111** on memory array **112.**

A set of select inputs may include five inputs, a selection signal input **SEL,** a fifth bit address input **AD [4],** a higher order select input **YS_H**, a lower order select input **YS_L** and a select input **YS.**

Byte selectors **(215-0** to **215-15)** receive a select signal (**YS0** to **YS15)** at select input **YS.** Select input **YS** may be enabled in a 16-bit operation mode. Select input **YS** may receive a select signal (**YS0** to **YS15**). In a 16-bit operation mode, select signal (**YS0** to **YS15)** received at select input **YS** may be output to both byte select outputs **BS_L** and **BS_H**. In an 8-bit operation mode, a select input **YS** may be disabled.

Each byte selector **(215-0** to **215-7)** in the first byte selector group may receive a group of select signals **(YS0-YS1** to **YS14-YS15),** respectively. For each byte selector **(215-0** to **215-7)** a respective low order select signal **(YS0, YS2,** ..., **YS14)** may be received at the low order select input **YS_L** and a respective high order select signal **(YS1, YS3,** ...**, YS14)** may be received at the high order select input **YS_H**.

Likewise, each byte selector **(215-8** to **215-15)** in the second byte selector group may receive a group of select signals **(YS0-YS1** to **YS14-YS15),** respectively. For each byte selector **(215-8** to **215-15)** a respective low order select signal **(YS0, YS2,** ...**, YS14)** may be received at the low order select input **YS_L** and a respective high order select signal **(YS1, YS3,** ...**, YS14)** may be received at the high order select input **YS_H**.

Each byte selector **215** may provide byte select outputs **(BS_L** and **BS_H)**. Each byte selector **215** may be connected to select a pair of columns of memory cells in accordance with byte select outputs **(BS_L** and **BS_H)**. Byte select output **BS_L** may select an even column, for example, of memory cells of memory array **112**. Byte select output **BS_H** may select an odd column, for example, of memory cells of memory array **112**. An even column and an odd column of memory cells selectable by byte select outputs (**BS_L** and **BS_H**) may be adjacent columns, for example.

In an 8-bit operation mode, either **BS_L** or **BS_H** may be active. A received select signal at select input **YS_H** may be output as byte select signal **BS_H** in activated byte selector **215.** A received select signal at select input **YS_L** may be output as byte select signal **BS_L** in an activated byte selector **215.**

In a 16-bit operation mode, both byte select signals **BS_L** and **BS_H** may serve as a select output for data values received in select input **YS.**

A particular example of an operation involving first Y-decoder **211** and first byte selector in second Y-decoder **212** will now be described.

A first byte selector **215-0** may include five select inputs including a selection signal input **SEL,** a fifth bit address input **AD [4],** a lower order select input **YS_L**, a higher order select input **YS_H**, and a select input **YS**. A first byte selector **215-0** may include two select signals **BS_L** and **BS_H** that may be connected to an odd column and an even column memory cell. Similarly, a second byte selector **215-1** may include two select outputs **BS2** and **BS3** that may be connected to an odd column and an even column memory cells. An odd and an even column may be adjacent columns, for example.

Each byte selector **215** may receive a selection signal input **SEL**. A selection signal input **SEL** may be generated by selection signal generating circuit **202** and universally applied to each byte selector **215.** A selection signal input **SEL** may control whether an operation may be in an 8-bit mode or a 16-bit mode in all byte selectors **215**.

A fifth bit address input **AD [4]** may determine whether an address has a fifth bit value. A fifth bit address may be "0" or "1".

In an 8-bit mode, a lower order select input **YS_L** may receive a first select input from **YS0** and output it to a lower order select input **BS_L** in first byte selector **215-0.** Similarly, a higher order select input **YS_H** may receive a select input from a second select input **YS1** in a first Y-decoder **211** and output to a higher order select output **BS_H** in first byte selector **215-0.**

Thus, a lower order select output **BS_L** may select an even column **0** of memory cells in memory array **112**. A select output **BS0** may select an even column **0** of memory cells. A higher order select output **BS_H** may select an odd column **1** of memory cells in a pair of memory cells **(0-1)** and output select output signal **BS1** to a memory cell **1**.

Another particular example of an operation involving first Y-decoder **211** and 8^{th} byte selector in second Y-decoder **212** will now be described.

An 8th byte selector **215-7** may include a set of select inputs and select outputs. Select inputs may include a selection signal input **SEL,** a fifth bit address input **AD [4],** a lower order select input **YS_L,** a higher order select input **YS_H** and a select input **YS** that may receive a 16-bit data value. 8th byte selector **215-7** may include select outputs **BS_L** and **BS_H** that may be connected to an even column **14** of memory cells and an odd column **15** of memory cells.

An input **AD [4]** may provide a fifth bit address value. Fifth bit address input **AD [4]** may be the same as that received in byte selectors **215-0** to **215-7.** However, fifth bit address input **AD [4]** may be different from that received in byte selectors **215-8** to **215-15**. Inverter **216** may invert an initial fifth bit address input **AD [4]** to an input **AD [4]'** and output it to byte selectors **215-8** to **215-15.**

**A** selection signal **SEL** generated by selection signal generating circuit **202** may control an operation mode. Whether a data processing operation is an 8-bit or a 16-bit may depend upon selection signal **SEL**. As but one example, selection signal **SEL** having a high logic level may indicate an 8-bit operation mode. Selection signal **SEL** having a low logic level may indicate a 16-bit operation mode.

A lower order select input **YS_L** may receive a select input from a fifteenth select input **YS14** and select output **YS14** to a lower order select input **BS_L** in 8th byte selector **215-7.** Similarly, a higher order select input **YS_H** may receive a select input from a sixteenth select input **YS15** and output **YS15** to a higher order select output **BS_H** in an 8th byte selector **215-7**. Thus, a lower order select output **BS_L** may output **BS14** to a memory cell **14.** A higher order select output **BS_H** may output **BS15** to a memory cell **15.**

The relationship between a select input and its corresponding select output signal by byte selector **215** will be illustrated in Truth Table **1.**

**Table 1**

| Truth | | | | | | | |
|---|---|---|---|---|---|---|---|
| Mode | Input | | | | | Output | |
| 8-bit mode | **SEL** | **AD[4]** | **YS_H** | **YS_L** | **YS** | **BS_H** | **BS_L** |
| | 1 | 0 | 0 | 0 | 0 | 0 | 0 |
| | 1 | 0 | 0 | 1 | 0 | 0 | 0 |
| | 1 | 0 | 1 | 0 | 0 | 0 | 0 |
| | 1 | 0 | 0 | 0 | 1 | 0 | 0 |
| | 1 | 1 | 0 | 0 | 0 | 0 | 0 |
| | 1 | 1 | 0 | 1 | 0 | 0 | 1 |
| | 1 | 1 | 1 | 0 | 0 | 1 | 0 |
| | 1 | 1 | 0 | 0 | 1 | 0 | 0 |

| 16-bit mode | 0 | 0 | 0 | 0 | 0 | 0 | 0 |
|---|---|---|---|---|---|---|---|
| | 0 | 0 | 0 | 1 | 0 | 0 | 0 |
| | 0 | 0 | 1 | 0 | 0 | 0 | 0 |
| | 0 | 0 | 0 | 0 | 1 | 1 | 1 |
| | 0 | 1 | 0 | 0 | 0 | 0 | 0 |
| | 0 | 1 | 0 | 1 | 0 | 0 | 0 |
| | 0 | 1 | 1 | 0 | 0 | 0 | 0 |
| | 0 | 1 | 0 | 0 | 1 | 1 | 1 |

In an 8-bit mode operation, byte selector **215** may receive selection signal **SEL** having a high logic level. A **YS** column may be inoperative during an 8-bit mode operation. At any given time, there may be only one high select input of 16 select inputs **YS (0-15)** that may be received at second Y-decoder **212.** Thus, either select input **YS_H** or **YS_L** may have a data value "1". When a fifth bit address bit input **AD[4]** is "1", a lower select output **BS_L** may output a select input received from a lower order select input **YS_L**. Similarly, at another time, a higher order select output **BS_H** may output a select input "1" received from a higher order select input **YS_H**.

In a 16-bit mode operation, byte selector **215** may receives selection signal **SEL** having a low logic level. Both **YS_H** and **YS_L** columns are inoperative during a 16-bit mode operation **YS** column is active. Byte selector **215** may receive a select input **YS** "1" and output to both select outputs **BS_H** and **BS_L**.

Having described structural components of a cell selecting circuit including a first and a second Y-decoder **211** and **212** according to one embodiment **300,** the operation will be described.

In a particular embodiment, when it receives a 4-bit column address **AD [3:0]**, first Y decoder **211** may decode **AD [3:0]** into a 16-bit decode value **(YS0-YS15)**. Second Y-decoder **212** may further decode a 16-bit decode signal to a 32-bit decode value **(BS0-31)** by using a fifth bit address value **AD[4]**.

Fifth bit address value **AD[4]** may be inputted to first 8 byte selectors **215 (0-7)** and inverted **AD[4]'** may be inputted to second 8 byte selectors **215 (8-15).** When a fifth bit address value is "1", first 8 byte selectors **215** may receive bit value "1" and second 8 byte selectors **215 (8-15)** may receive an inverted fifth address value "0".

In this way, when selection signal generating circuit **202** generates selection signal SEL that indicates an 8-bit operation mode, second Y-decoder **212** generate a column address corresponding to one column from 32 columns on memory array **112**.

X-decoder **113** generates a row address that corresponds to a row in memory array **112.** Thus, a pair of row and column addresses may correspond to a single memory cell **111** on memory array **112**. In this way, memory cell **111** may be selected.

On the other hand, when a selection signal generating circuit **202** generates selection signal **SEL** that indicates a 16-bit operation mode, second Y-decoder **212** may generate a column address corresponding to two columns from 32 columns on memory array **112.** X-decoder **113** may generate a row address that corresponds to a row in memory array **112**. Byte selector **215** receives select input **YS** to output it to two select outputs **BS_H** and **BS_L**. Thus, a pair of row and column address values may correspond to a single memory cell on memory array **112**. In this way, a memory cell storing a16-bit data value may be selected.

Write circuit **213** may write data values to a selected memory cell **111** on memory array **112**. Read circuit **214** may read data values stored in a selected memory cell **111** and output the read data values.

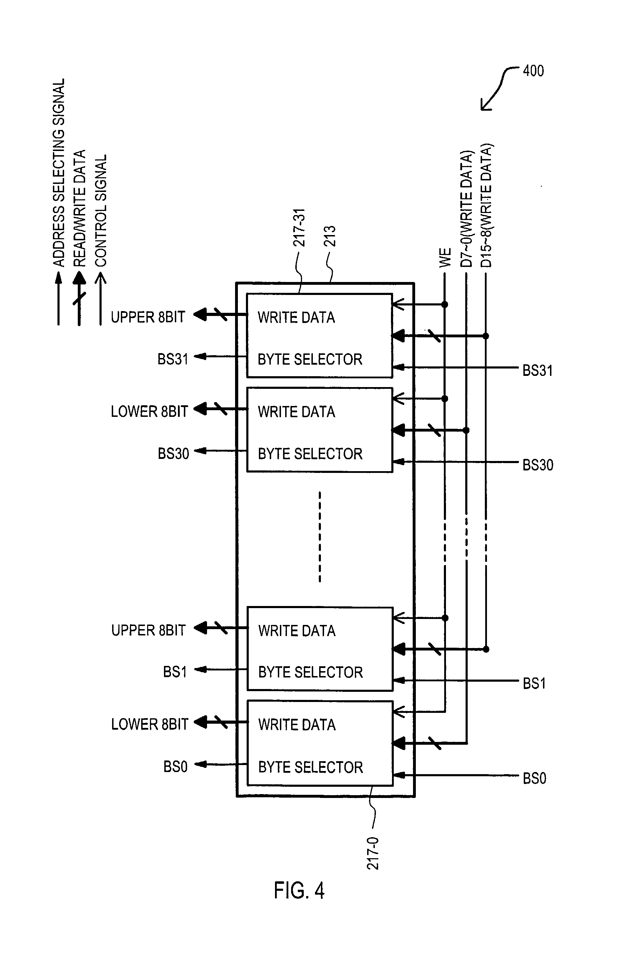

Referring to FIG. 4, a write circuit according to one embodiment is set forth and designated by the general reference number **400.** A write circuit according to one embodiment **400** may include 32 individual writing circuits **217 (0-31).** Write circuit **400** may be connected to a memory array **112.**

Each individual writing circuit **217 (0-15)** may include a byte selector **BYTE** **SELECTOR** and a data writing circuit **WRITE DATA.** Byte selector **BYTE SELECTOR** and data writing circuit **WRITE DATA** may be connected to memory array **112**. An even-numbered byte selector **BYTE SELECTOR** may be connected to a corresponding even number column in 32-column memory array **112**. Similarly, an odd number byte selector **BYTE SELECTOR** may be connected to a corresponding odd number column in 32-column memory array **112**. As but one example, a first byte selector **0** may be connected to a first column of memory array **112**. A second byte selector **1** may be connected to a second column of memory array **112.**

Having described writing circuit **400,** a write operation will now be described in detail.

Each individual writing circuit **217 (0-31)** may receive a write command **WE**, a select input **BS,** an 8-bit **D7-0** lower order of a 16-bit data value or an 8-bit upper **D15-8** lower order of a 16-bit data value. All 32 individual writing circuits **217** (**0-31**) may be divided into 16 groups. Each group may include a pair of byte selectors. A pair of byte selectors may include an even number one and an odd number one. Typically, an even number byte selector in a pair may be a lower order one; an odd number byte selector in a pair may be a higher order one.

In particular arrangements, an even number writing circuit may receive an 8-bit **D7-0** lower order of a 16-bit data value and an odd number a writing circuit may receive an 8-bit **D15-8** upper order of a 16-bit data value. More specifically, an 8-bit **D7-0** lower order of a 16-bit data value may be transmitted over to a lower order byte selector in a pair of byte selectors. An 8-bit **D15-8** upper order of a 16-bit data value may be transmitted over to an upper order of byte selector in a pair of byte selectors.

In this way, an even number writing circuit may output an 8-bit **D7-0** lower order of a 16-bit data value to an even number column on memory array **112**. Similarly, an odd number writing circuit may output an 8-bit **D15-8** upper order of a 16-bit data value.

For example, an 8-bit **D7-0** lower order of a 16-bit data value may be generated. Upon receiving write command **WE,** all even number individual writing circuits **217 (0-14)** may receive and output an 8-bit **D7-0** lower order of a 16-bit data value to all even number columns **0-30** on memory array **112**. Similarly, an 8-bit **D15-7** upper order of a 16-bit data value may be generated and received by all odd number individual writing circuits **217 (1-31)**. All odd number individual writing circuits **217 (1-31)** may output an 8-bit **D15-7** upper order of a 16-bit data value to all odd number columns **1-31** on memory array **112.**

A write operation may operate either in an 8-bit mode or a 16-bit mode. Depending upon selection signal **SEL** that may be received at a byte selector, a write operation may perform an 8-bit mode or a 16-bit mode operation.

For example, a write operation may perform an 8-bit mode when selection signal **SEL** having a high logic level is received. Only one column on memory array **112** may be selected to receive an 8-bit data value. On the other hand, a write operation may perform a 16-bit mode when selection signal **SEL** having a low logic level is received. Two adjacent columns on memory array **112** may be selected to process a 16-bit data value, for example.

Unlike a conventional circuit, a single data storage circuit may read or write 8-bit and 16-bit data values. The number of circuits may be significantly reduced and significant. Therefore, a data storage circuit according to embodiments of the present invention may increase data processing efficiency.

It is also understood that an operation circuit may receive a data value with more than 16-bit. An 8n-bit operation mode with data values having N times of a minimum 8-bit size (8n-bit) may also be controlled by selection signal **SEL**. A cell selecting circuit may select N-number columns in memory array **112** to receive 8n-bit of data values. In addition, a minimum data bit may be more or less than 8-bit as illustrated in the particular embodiments of present inventions. Furthermore, a memory array can include a plurality of sub-arrays, as just an example.

Thus, while the embodiments set forth herein have been described in detail, it should be understood that the present invention could be subject to various changes, substitutions, and alterations without departing from the spirit and scope of the invention. The present invention may not be limited to the above embodiments and may vary without departing from the essence of the present invention. Accordingly, the present invention is intended to be limited only as defined by the appended claims.

## Claims

1. A data processing apparatus, comprising:
a selection circuit that selects a first plurality of data bits from a memory array in a first mode and selects N times the first plurality of data bits from the memory array in a second mode wherein N is an integer of 2 or greater.

2. The data processing apparatus of claim 1, wherein:
the selection circuit is coupled to a data bus for receiving at least the first plurality of data bits and coupled to a first and a second processor and the first processor has a different data width than the second processor.

3. The data process apparatus of claim 1 wherein the selection circuit provides a plurality of decode signals, the data processing apparatus further including:
a data write circuit coupled to receive the plurality of decode signals and writes to memory cells storing the first plurality of data bits in the memory array in the first mode and writes to memory cells storing the N times the first plurality of data bits in the memory array in the second mode.

4. The data process apparatus of claim 1 wherein the selection circuit provides a plurality of decode signals, the data processing apparatus further including:
a data read circuit coupled to receive the plurality of decode signals and provide the first plurality of data bits from the memory array in the first mode and provide the N times the first plurality of data bits from the memory array in the second mode.

5. A data processing apparatus, comprising:
a memory array having a plurality of columns and rows of memory cells;
a width-selection signal having an n-bit width logic level and an m-bit width logic level, n being an integer greater than 1 and m being greater than n;
a cell selecting circuit coupled to receive a plurality of address bits and output a plurality of decode signals; and
a data write circuit coupled to receive the plurality of decode signals and write n-bit data to the memory array when the width-selection signal has the n-bit width logic level and m-bit data into the memory array when the width-selection signal has the m-bit logic level.

6. The data processing apparatus of claim 5, wherein:
each selector circuit of the plurality of selector circuits generates the at least two decode signals based on select signals and the width-selection signal; and
an activated selector circuit of the plurality of selector circuits provides a first number of active decode signals when the width-selection signal has the m-bit logic level and less than the first number of active decode signals when the width-selection signal has the n-bit logic level.

7. The data processing apparatus of claim 6, wherein:
a decoder provides the select signals in accordance with at least a first and second address bit of the plurality of address bits.

8. The data processing apparatus of claim 5 , further including:
a width-selection signal generating circuit generating the width-selection signal.

9. The data processing apparatus of claim5, wherein:
n is eight and m is an integer multiple of eight.

10. The data processing apparatus of claim 5, further including:
an address generating circuit coupled to provide the plurality of address bits.

11. A data processing apparatus, comprising:
**a** memory array having a plurality of columns and rows of memory cells;
**a** width-selection signal having an n-bit width logic level and an m-bit width logic level, n being an integer greater than 1 and m being greater than n;
**a** cell selecting circuit coupled to receive a plurality of address bits and output a plurality of decode signals; and
**a** data read circuit coupled to receive the plurality of decode signals and n-bit data to the memory array when the width-selection signal has the n-bit width logic level and m-bit data into the memory array when the width-selection signal has the m-bit logic level.

12. The data processing apparatus of claims 5 or 11, wherein:
the cell selecting circuit includes a plurality of selector circuits, each selector circuit coupled to receive the width-selection signal and provide at least two decode signals of the plurality of decode signals.

13. The data processing apparatus of claim 12, wherein:
each selector circuit of the plurality of selector circuits generates the at least two decode signals based on select signals and the width-selection signal; and
an activated selector circuit of the plurality of selector circuits provides a first number of active decode signals when the width-selection signal has the m-bit logic level and less than the first number of active decode signals when the width-selection signal has the n-bit logic level.

14. The data processing apparatus of claim12, wherein:
the plurality of selector circuits include a first selector group and a second selector group that are selectable in accordance with a third address bit of the plurality of address bits..

15. The data processing apparatus of claims 1 or 11, wherein:
the data processing apparatus is included on a semiconductor device.

16. The data processing apparatus of claim 11, further including:
a data write circuit coupled to receive the plurality of decode signals and write the n-bit data to the memory array when the width-selection signal has the n-bit width logic level and the m-bit data into the memory array when the width-selection signal has the m-bit logic level.

17. The data processing apparatus of claim 11, wherein:
m is an integer multiple of n.
